Europäisches Patentamt

European Patent Office

Office européen des brevets

(11) Publication number: **0 153 451**
A1

# EUROPEAN PATENT APPLICATION

(21) Application number: **84113208.7**

(22) Date of filing: **02.11.84**

(51) Int. Cl.⁴: **B 23 K 1/12**
//H01L23/40

(30) Priority: **23.02.84 JP 23914/84 U**

(43) Date of publication of application:
**04.09.85 Bulletin 85/36**

(84) Designated Contracting States:
**DE FR GB NL**

(71) Applicant: **Umeda Kogyo Co., Ltd.**
**1-4-13, Sakuramachi**
**Kumagaya-city Saitama-prefecture(JP)**

(72) Inventor: **Umeda, Teruyuki**
**1-4-13, Sakuramachi**
**Kumagaya-city Saitama-prefecture(JP)**

(74) Representative: **Goddar, Heinz J., Dr. et al,**
**FORRESTER & BOEHMERT Widenmayerstrasse 4/I**
**D-8000 München 22(DE)**

(54) **A structure for fixing part of a member that is difficult to braze.**

(57) This invention relates to a structure for fixing a portion of a difficult to braze member which makes it possible to fix, by brazing or soldering, a member that can not directly be brazed or soldered to a substrate or the like, such as a heat radiating sheet of an electronic component, to the substrate or the like.

*F I G. 3*

EP 0 153 451 A1

# S P E C I F I C A T I O N

TITLE OF THE INVENTION:

A STRUCTURE FOR FIXING PART OF A MEMBER

THAT IS DIFFICULT TO BRAZE

## BACKGROUND OF THE INVENTION

This invention relates to a structure for fixing a portion of a difficult to braze member which is suitable when fixing a member that can not easily be brazed or soldered, such as a heat radiating sheet of an electronic component, to a substrate or the like by brazing or soldering.

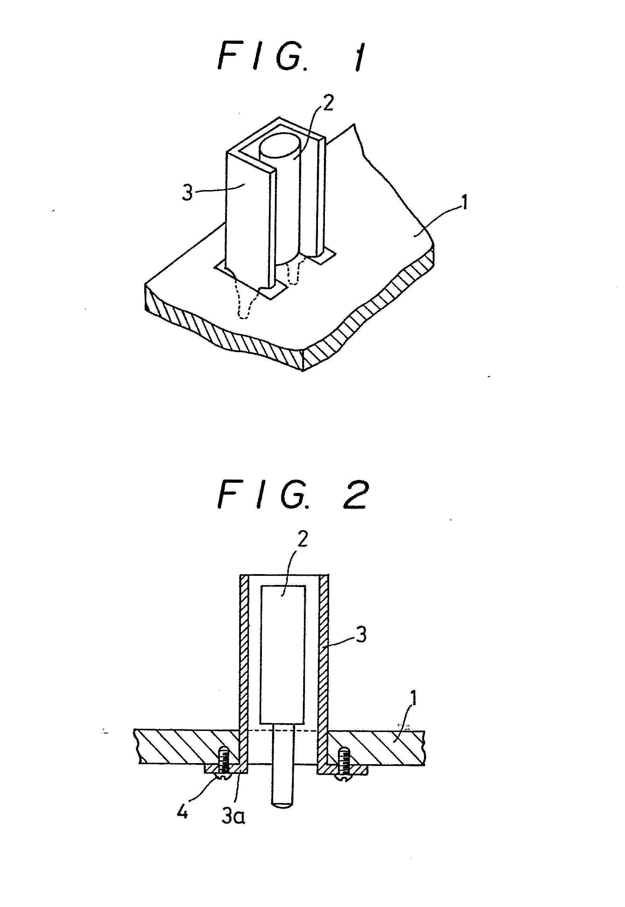

A heating radiating sheet 3 is disposed around an electronic component 2 fitted to a substrate 1 of an electronic appliance or the like, as shown in Figure 1, to cool the electronic component 2. This heat radiating sheet 3 must be fixed to the substrate 1. Though aluminum or iron is generally used for the heat radiating sheet 3, these metals can not easily be soft brazed, hard brazed or soldered; nor can they easily be fitted to the substrate 1 by brazing or soldering. Besides being fixed to the heat radiating sheet 3 of the electronic appliance, difficult to braze members must often be fixed to a sheet member such as the substrate 1.

Figure 2 illustrates an example of the prior art method of fixing a difficult to braze member such as

0153451

the heat radiating sheet 3 to the substrate.  This method has been primarily used to this date, as disclosed in Japanese Utility Model Publication Nos. 50054/1978 and 52590/1978, for example.  After a fixing portion 3a of the heat radiating sheet 3 is inserted into the substrate 1, the tip is bent as shown in the drawing, and is then fixed to the substrate 1 with a screw 4.  Though the heat radiating sheet 3 can be fixed by this method, it is by no means easy to fix the sheet to the substrate with the small screw 4.  When many heat radiating sheets 3 must be fitted, therefore, considerable time is necessary for fitting.  Another fixing method is disclosed in Japanese Utility Model Publication No. 32269/1960, not shown.  This method forms a slit at the fixing portion 3a and fixes the sheet by inserting a clip or the like into the slit, or plates the fixing portion 3a with a brazable material and then brazes or solders the sheet to the substrate 1. The former presents a problem in that many man-hours are spent as in the method already described and fixing is not positive, while the latter also presents a problem in that the cost of the work is high, and the plating sometimes peels off the fixing portion and drops onto the substrate, thereby causing short-circuits or making the fixing unstable.  Though a heat radiating

- 2 -

sheet such as disclosed in U.S. Patent No. 4,054,901 is known, no contrivance has been made in which the fixing method employs a tab.

## SUMMARY OF THE INVENTION

To eliminate the problem described above, the present invention is directed to provide a structure for fixing a portion of a difficult to braze member which can provide reliable fixing and can be put into practice easily and economically.

To accomplish the object described above, the present invention provides a structure for fixing a portion of a difficult to braze member in which an attachment made of a brazable material is fitted to the fixing portion of the difficult to braze member, an anchor portion for anchoring the attachment is formed in the proximity of the fixing portion so as to anchor the attachment to the anchor portion, and the anchor portion is brazed or soldered to a substrate or the like to fix the difficult to braze member.

## BRIEF DESCRIPTION OF THE DRAWINGS

Figure 1 is a perspective view showing the fitting state of a heat radiating sheet of an electronic component as an example of a difficult to braze material;

Figure 2 is a sectional view showing the conventional fixing means for fixing the heat radiating sheet;

Figure 3 is a partial sectional view of one embodiment of the present invention;

Figure 4 is a perspective view of an attachment in the embodiment in the present invention;

Figure 5 is a partial enlarged view showing the anchored state between the attachment and the heat radiating sheet;

Figure 6 is a partial enlarged view showing another anchor means different from the attachment; and

Figure 7 is a partial sectional view showing another example of the attachment.

DESCRIPTION OF THE PREFERRED EMBODIMENT

Hereinafter, a preferred embodiment of the present invention will be described with reference to the accompanying drawings.

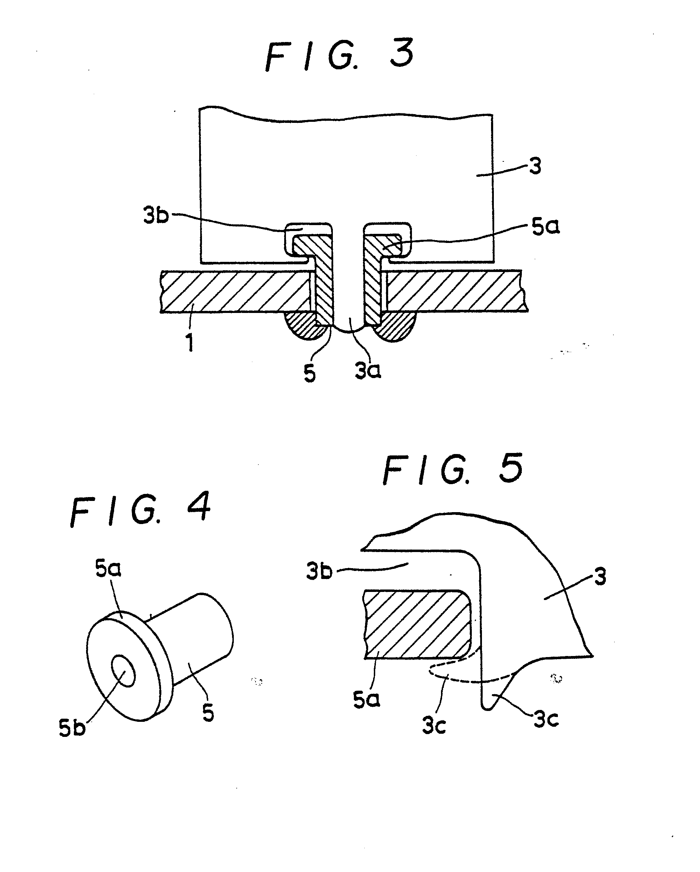

As shown in Figure 3, the fixing portion 3a of a heat radiating sheet 3 is extended in tongue-like form, and an attachment 5 is fitted to this fixing portion.

As also shown in Figure 4, the attachment 5 consists of a cylindrical tube such as an eyelet having a flange 5a, and its inner hole 5b is preferably such that the fixing portion 3a can be inserted or fitted thereto. Though copper, brass, solder-plated or tin-plated materials are preferred as the material of the attachment 5, other materials can also be used so long as they can be soft brazed or hard brazed. A recess 3b is formed at the root of the fixing portion 3a of the heat radiating sheet 3 so that the flange 5a of the attachment 5 can be fitted to the same. A protuberance 3c as an anchor portion is formed at the end portion of the recess 3b as shown in Figure 5. The recess 3b and the protuberance 3c are shaped simultaneously with the fixing portion 3a and the like when the heat radiating sheet 3 is press-molded.

Next, the operation of this embodiment will be described.

First the attachment 5 is fitted to the fixing portion 3a of the heat radiating sheet 3. In this case, the flange 5a of the attachment 5 enters the recess 3b. Next, the protuberance 3c is bent as indicated by dotted line in Figure 5 so as to anchor the protuberance 3c to the flange 5a. Thus, the attachment 5 is caulked to the heat radiating sheet 3. Since the attachment is molded in the cylindrical shape as described above, the fixing portion 3a is encompassed by the attachment 5.

While the attachment 5 is fitted, the heat radiating sheet 3 is inserted into the substrate 1, and the attachment 5 and the substrate 1 are joined by soldering or brazing, whereby the heat radiating sheet 3 is fixed to the substrate 1 via the attachment 5. Brazing or soldering of the substrate 1 is the work that has
been practised customarily when assembling electronic
components and can be carried out easily and economically without any particular difficulty.  The attachment 5 itself is not very expensive, and the same or
similar attachments can be obtained easily and economically.  No problem is encountered when molding the
protuberance 3c because it is molded by simultaneous
press-molding as described above, and its caulking by
bending does not present any problem because the sheet
is thin.

In this embodiment, the protuberance 3x is bent
after the attachment 5 is inserted into the recess 3b.
However, it is also possible to employ a method involving the steps of forming the protuberance 3c, which is
bent in advance, engaging a slit, not shown, formed on
the flange 5a of the attachment 5 with the protuberance
3c, pushing the flange 5a of the attachment 5 into the
recess 3b, and thereafter rotating the attachment 5
so as to anchor it inside the recess 3b.

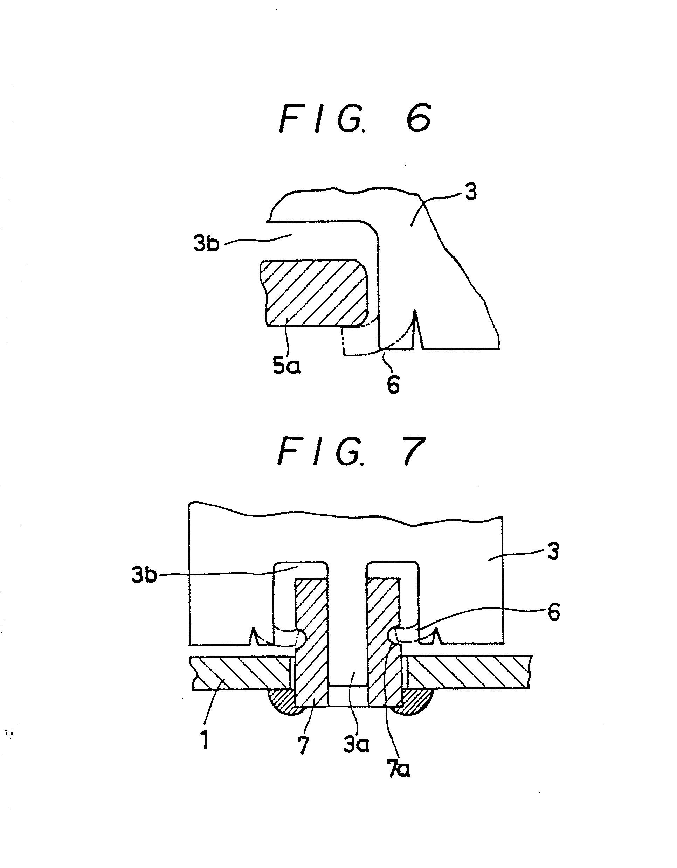

Figure 6 shows another example for fixing the
attachment 5.  A notch is made in the proximity of the
end portion of the recess 3b with a chisel or the like
to form the anchor portion 6.  After the flange 5a
of the attachment 5 is inserted into the recess 3b, the anchor portion 6 is bent and anchored to the flange 5a of the attachment 5.

Figure 7 shows another example of the attachment. This attachment does not have a flange, but is shaped in a cylindrical, sleevelike form, and the recess 7a is formed at its intermediate portion. This attachment 7 is fitted to the fixing portion 3a and the anchor portion 6 and the like is anchored to the recess 7a in the same way as described above, so that the attachment 7 is held in place and is thereafter brazed to the substrate 1 in the same way as described above.

Also, the protuberance 3c and the anchor portion 6 can be omitted by firmly fitting the attachment 5 or 7 to the fixing portion 3a.

As can be understood clearly from the description given above, the present invention can make fixing more reliable and can be worked easily and economically.

What is claimed is:

1.  A structure for fixing a portion of a difficult to braze member characterized in that an attachment made of a brazable material is fitted to the fixing portion of said difficult to braze member, and an anchor portion for anchoring said attachment is formed in the proximity of said fixing portion.

2.  The structure for fixing a portion of a difficult to braze member as defined in claim 1 wherein said attachment is made of copper.

3.  The structure for fixing a portion of a difficult to braze member as defined in claim 1 wherein said attachment is made of brass.

4.  The structure for fixing a portion of a difficult to braze member as defined in claim 1 wherein said attachment is made of a solder-plated material.

5.  The structure for fixing a portion of a difficult to braze member as defined in claim 1 wherein said attachment is made of a tin-plated material.

6.  The structure for fixing a portion of a difficult to braze member as defined in claim 1 wherein said attachment is molded in a cylindrical form.

7.  The structure for fixing a portion of a difficult to braze member as defined in claim 6 wherein said attachment has an eyelet shape having a flange.

8. The structure for fixing a portion of a difficult to braze member as defined in claim 6 wherein said attachment has a sleeve-like shape not having a flange.

9. The structure for fixing a portion of a difficult to braze member as defined in claim 1 wherein said anchor portion is a protuberance.

10. The structure for fixing a portion of a difficult to braze member as defined in claim 1 wherein said anchor portion is a notch formed in the proximity of said fixing portion.

11. The structure for fixing a portion of a difficult to braze member as defined in claim 1 wherein said anchor portion pushes said attachment in the proximity of said fixing portion.

F I G. 1

F I G. 2

# FIG. 3

# FIG. 4

# FIG. 5

F I G. 6

F I G. 7

**European Patent Office**

**EUROPEAN SEARCH REPORT**

Application number

| DOCUMENTS CONSIDERED TO BE RELEVANT | | EP 84113208.7 |

| Category | Citation of document with indication, where appropriate, of relevant passages | Relevant to claim | CLASSIFICATION OF THE APPLICATION (Int Cl 4) |
|---|---|---|---|
| A | GB - A - 2 032 827 (BUNKER) <br> * Fig. 5 * <br> ---- | | B 23 K 1/12 <br> //H 01 L 23/40 |
| | | | **TECHNICAL FIELDS SEARCHED (Int Cl 4)** |
| | | | B 23 K 1/00 <br> B 23 K 3/00 <br> B 23 K 31/00 <br> H 01 R 4/00 <br> H 01 R 43/00 <br> H 01 L 23/00 |

The present search report has been drawn up for all claims

| Place of search | Date of completion of the search | Examiner |
|---|---|---|
| VIENNA | 24-04-1985 | BENCZE |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document